# EUROPEAN PATENT APPLICATION

(11) **EP 3 671 828 A1**
(43) Date of publication of application: **24.06.2020**
(21) Application number: 18215526.7
(22) Date of filing: 21.12.2018
(51) Int. Cl.: H01L 23/427, F28F 13/06, F28D 15/02, H01L 23/367

(54) **EVAPORATIVE MICROCHIP COOLING**

(71) Applicant: Nederlandse Organisatie voor toegepast- natuurwetenschappelijk onderzoek TNO, 2595 DA 's-Gravenhage (NL)
(72) Inventor: BULLEMA, Jan Eite, 2595 DA `s-Gravenhage (NL); ROPS, Cornelius Maria, 2595 DA `s-Gravenhage (NL)
(74) Representative: V.O.

(57) **Abstract**

The invention pertains to a method of method of cooling a microchip, using vaporization of a cooling liquid in a vaporization chamber of a cooling element wherein the vaporization chamber comprises channels and a plurality of flow-modifying structures.

## Description

### Field of the invention

The invention pertains to a cooling element, an assembly comprising a microchip and a cooling element, a method of manufacturing a cooling element, and a method of cooling a microchip.

The invention pertains in particular to arrangements for the cooling of semiconductor or other solid state devices involving the transfer of heat by flowing liquids.

### Background

The invention pertains to the cooling of integrated circuits on microchips, and more in particular to evaporative cooling of electronic integrated circuits on or in semiconductor-based microchips. The evaporative cooling involves the boiling of a cooling liquid which is flowing through channels in the proximity of the microchip or integrated circuit.

Conventional channel cooling for electronic devices such as microchips with integrated circuits provides for a cooling power (heat dissipation level) of typically maximum 0.18 W/cm² and has for instance heat transfer coefficient of maximum 1800 W/(m²K). In particular, the invention pertains in embodiments to small-scale cooling elements providing chip-level heat dissipation levels exceeding 1.0 kW/cm² for example while maintain the chip at a temperature below 150°C or below 120°C, and usually against ambient temperature e.g. in the range of 5 to 30 °C. Such heat dissipation levels are for instance useful for operation of current and next-generation radar systems, power electrons systems, telecommunication systems, and high performance computing systems. The invention also pertains to a cooling unit providing for a heat transfer coefficient of preferably at least 0.50 MW/(m²K) or even preferably at least 1.0 MW/(m²K)

Especially in certain kinds of microchips cooled according to the invention, hotspots may occur with a heat flux of more than 1 kW/cm², such as hotspot heat fluxes of more than 1.5 kW/cm², more than 2.0 kW/cm², or even 2.5 kW/cm² or more, in some embodiments up to 3.0 kW/cm² though higher hotspot heat fluxes are possible. Such hotspots have for instance a size of at least 1000 µm² or at least 10.000 µm², and for instance less than 1.0 mm² or less than 0.10 mm².

Furthermore, the invention pertains to cooling solutions for 5G microchips, hence for microchips (and other integrated circuit systems) for the fifth generation of cellular mobile communications, although the cooling element may be used for any generation of cellular mobile communications or more broadly, wireless communication network, and also for other types of microchips and integrated circuits.

The article "Evaporative Intrachip Hotspot Cooling with a Hierarchical Manifold Microchannel Heat Sink Array" of Drummond et al., 15th IEEE ITHERM Conference (2016), DOI: 10.1109/ITHERM.2016.7517565, describes the use of an array of intrachip silicon microchannel heat sinks fed in parallel using a manifold distributor to dissipate heat from a small hotspot region. It is observed that the heat transfer coefficient reduces sharply with heat flux after a maximum is reached, which may be caused by local/intermittent dry-out at the wall or flow instabilities that decrease flow to individual channels. Furthermore a magnetically-coupled gear pump is used to circulate the fluid (flowrate 100 to 500 ml/min) through the test section.

An objective of the present invention is to address these disadvantages at least in part, in particular to address the disadvantages of local/intermittent dry-out at the wall and of flow instabilities.

In particular, it is desired to provide a cooling element for evaporative cooling of microchips which have integrated circuits, wherein high heat flux can be achieved, while requesting relatively low flow rates.

A further objective is to provide a cooling element for evaporative cooling of microchips which does not include a pump.

### Summary

The invention relates in a first aspect to a method of cooling a microchip, which microchip comprises an integrated circuit and is assembled or integrated with a cooling element, wherein the cooling element comprises a vaporization chamber comprising a heat exchanging wall, wherein the integrated circuit is arranged adjacent to a first side of said heat exchanging wall, wherein the method comprise providing a cooling liquid to said vaporization chamber in contact with a second side of said heat exchanging wall, wherein said second side is opposite of said first side, such that heat is exchanged from said integrated circuit to said cooling liquid thereby vaporizing said cooling liquid into vapor wherein the vaporization chamber comprises channels and a plurality of flow-modifying structures that are arranged in series in the direction of the flow of the coolant liquid, such that the flow of the coolant liquid and the vapor is modified while the coolant liquid and the vapor flow through said channels in said vaporization chamber and in contact with said heat exchanging wall, and wherein the cooling element comprises an inlet for coolant liquid at a first side of the vaporization chamber, and an outlet for vapor at an opposite second side of said vaporization chamber, wherein a length direction of the vaporization chamber is from said inlet to said outlet.

The invention also pertains to an assembly comprising a microchip and a cooling element, wherein the microchip is provided with an integrated circuit, wherein the cooling element comprises a vaporization chamber comprising a heat exchanging wall, wherein the microchip is arranged adjacent to a first side of said heat exchanging wall, wherein the heat exchanging wall is configured for, in operation, exchanging heat from said microchip to a cooling liquid that is provided in said vaporization chamber in contact with a second side of said heat exchanging wall, wherein said second side is opposite of said first side, thereby vaporizing said cooling liquid into vapor, wherein the vaporization chamber comprises channels and a plurality of flow-modifying structures that are arranged in series in the direction of the flow of the coolant liquid and that are each configured for modifying the flow of the coolant liquid and the vapor while the coolant liquid and the vapor are in said vaporization chamber and in contact with said heat exchanging wall, and wherein the cooling element comprises an inlet for coolant liquid at a first side of the vaporization chamber, and an outlet for vapor at an opposite second side of said vaporization chamber.

In a further aspect, the invention pertains to a cooling element suitable for cooling a microchip, wherein the cooling element comprises a vaporization chamber comprising a heat exchanging wall having a first side where, in operation, heat from an integrated circuit comprised in said microchip is provided, and a second side which is, in operation, in contact with a cooling liquid provided in the vaporization chamber such that said cooling liquid is vaporized to vapor, wherein said second side is opposite of said first side, wherein the vaporization chamber comprises channels and a plurality of flow-modifying structures that are arranged in series in the direction of the flow of the coolant liquid and that are each configured for modifying the flow of the coolant liquid and the vapor while the coolant liquid and the vapor are in said channels in said vaporization chamber and in contact with said heat exchanging wall, wherein the cooling element comprises an inlet for coolant liquid at a first side of the vaporization chamber, and an outlet for vapor at an opposite second side of said vaporization chamber, and wherein preferably said heat exchanging wall and said flow-modifying structures are monolithic with each other and are preferably made of a silicon based material.

In a further aspect, the invention pertains to a method of manufacturing a cooling element as mentioned, wherein in said cooling element said heat exchanging wall and said flow-modifying structures are monolithic with each other and are made of a silicon based material, and wherein in said cooling element, said flow-modifying structures are pillars extending perpendicular to said heat exchanging wall into said vaporization chamber, the manufacturing method comprising etching channels in a silicon wafer substrate, such that the silicon material remaining between the channels provides the flow-modifying structures.

### Brief description of the drawings

Figure 1 schematically illustrates an example assembly according to the invention.
Figure 2 shows a schematic top view of an example cooling element according to the invention. Fig. 2A shows an overview, Fig. 2B shows a magnified view of a portion of the cooling element, Fig. 2C shows a magnified view of a detail of the cooling element.
Figure 3 shows a top view of an example cooling element according to the invention.
Figure 4 shows a further top view of an example cooling element according to the invention.
Figure 5 schematically illustrates an example embodiment of an assembly according to the invention.
Figure 6 shows images of an example cooling element according to the invention at different magnifications (Fig. 6A, 6B and 6C).

### Detailed description

It has surprisingly been found that this objective can be met at least in part by using a vaporization chamber with flow-modifying structures, in particular with liquid slug break-up structures.

In an aspect, the invention is hence broadly based on the judicious insight that good evaporative cooling of microchips can be achieved by using a cooling element having channels for flow of a coolant liquid and structures that break up the flow of the vaporizing coolant in the channels. In particular, by the vaporization of the coolant liquid in the channels, vapor bubbles and liquid slugs are formed. In operation of the cooling element of the present invention, these liquid slugs impinge on the structures, which are e.g. pillars, and break up. In this way explosive bubble growth in the channels can be avoided and high flow rates of the coolant fluid can be maintained in the channels even at a low pressure drop.

As used herein "RF" refers to radio frequency, e.g. in the range of 20 kHz to 300 GHz). In a particular preferred embodiment, the microchip is used for mm wave signals (30 to 300 GHz).

The present invention is directed to the cooling of microchips with an integrated circuit, or to the cooling of an integrated circuit. The integrated circuit is for instance a set of electronic circuits on one piece of semiconductor material, the semiconductor material is for example silicon or based on silicon, other materials are also possible. The piece of semiconductor material is generally flat and relatively small (e.g. less than 10 cm²) and is referred to as a "microchip". The integrated circuit for instance includes a large number of transistors, e.g. more than 100 transistors, or more than 1000 transistors or even more than 1.000.000 transistors. However, the integrated circuit can also contain only passive elements, such as resistors, capacitors and inductors (in particular, elements having incremental passivity), with no active elements such as transistors. This can for instance be used for analogue circuits.

The microchip is typically manufactured using photolithography, and usually from a semiconductor sheet, such as a Si wafer. The microchip is for instance configured for data processing and calculations (microprocessors), memory storage, and/or for signal processing. The microchip may comprise digital logic circuits and/or for analogue circuits, and/or is configured for the processing of digital and/or analogue signals.

An "integrated circuit" as used herein includes for example an electronic circuit in which all or some of the circuit elements are inseparably associated and electrically interconnected, in particular so that it is considered to be indivisible for the purposes of construction and commerce. More in particular the integrated circuit is a monolithic integrated circuit and is based on a single monolithic piece of semiconductor material as substrate. The microchip and/or the integrated circuit may comprise non-electronic circuits, for instance to allow the integration of optical units, mechanical devices and sensors. For instance the microchip may comprise a microelectromechanical system, and/or an integrated optical circuit, e.g. based on photonics. The microchip may also be configured for spintronics (spin transport electronics).

In a particularly preferred embodiment, the microchip is a monolithic microwave integrated circuit (MMIC device), configured for operating at microwave frequencies (e.g. 300 MHz to 300 GHz). The semiconductor material of the MMIC device is for instance a class III-V compound semiconductor, such as GaAs, although for example a Si-based integrated circuit can also be used; other example semiconductor materials for the microchip include InP, SiGe and GaN. The MMIC device is for instance used for microwave mixing, power amplification, low-noise amplification, and high frequency switching, and for instance drives an antenna for wireless communication. The MMIC device is for instance configured as RF power amplifier.

In a preferred embodiment of the cooling method, the microchip is simultaneously used for generating a current to an antenna, preferably an alternating current, for instance with a frequency of at least 20 kHz, more typically a RF frequency of 300 MHz to 300 GHZ, and for example a current with a frequency of at least 24 GHz. The microchip for instance functions as RF power amplifier simultaneously with the cooling method.

In a preferred embodiment, the cooling element provides for a heat transfer coefficient of at least 0.5 x 10⁶ W/m².K or at least 0.70 x 10⁶ W/m².K.

There is a current trend towards ever higher heat dissipation rates of microchips comprising integrated circuits, for example for the various kinds of microchips as described. In particular the microchip may have in operation a need for heat dissipation levels for instance of at least 0.10 kW/cm², at least 0.50 kW/cm², or even at least 1.0 kW/cm², for example while maintaining the chip at a temperature below 150°C or below 120°C, or even below 70°C, and for instance against ambient temperature e.g. in the range of 5 to 30 °C, and for example on the chip level (average heat dissipation over the microchip). It is observed that depending on the available heat sink temperature, cooling to lower temperatures than ambient (e.g. below 0°C) is also possible, provided that the coolant liquid does not solidify in the heat sink.

Furthermore the microchip may have in operation a heat density of at least 1.0 kW/cm³ (i.e. on volume basis), more in particular as package-level volumetric heat generation, and for example with the microchip temperature and ambient temperature as described.

Furthermore the microchip may have in operation hotspots with a need for heat dissipation levels (heat flux of the cooling) of more than 1 kW/cm², such as hotspot heat fluxes of more than 2 kW/cm², more than 5 10 kW/cm², more than 10 kW/cm², or even more than 30 kW/cm², though higher hotspot heat fluxes are possible. Such hotspots have for instance a size of at least 1000 µm² or at least 10.000 µm², and for instance less than 1.0 mm² or less than 0.10 mm². The microchip temperature and ambient temperature for such cooling are preferably as described, e.g. a microchip temperature of less than 100°C or less than 60°C and ambient temperature e.g. in the range of 5 to 30°C.

It is observed that in some embodiments of the invention, the microchip may be specified in general as a heat source giving such heat flux, heat density and/or hot spots and typically being for the processing of electronic data and/or signals, without further restriction to the particular kind of microchip.

In some embodiments, the microchip has the integrated circuit lines arranged on one side of the planar semiconductor substrate; the side with IC lines is the topside, the other side is the backside of the microchip.

The microchip comprises for instance a device selected from the group consisting of an integrated circuit, a microprocessor, a system on a chip (for instance, including a central processing unit, a memory unit, input/output ports and optionally secondary storage on a single substrate), an RFIC (Radio Frequency Integrated Circuit, e.g. an RF transmitter or RF receiver), an optical transmitter or receiver, a power amplifier, for instance a radio frequency power amplifier, a GPU (graphics processing unit), a CPU (central processing unit), a digital signal processor, an application specific integrated circuit, an accelerated processing unit (APU), an light emitting diode (LED), a laser diode, and a power electronic device, e.g. a power invertor or a power convertor. The microchip may for instance also contain a photonic device, or a solar panel (especially used with a solar field).

In an example embodiment, the microchip comprises a RF power amplifier, which is an electronic amplifier that converts in operation a low-power RF signal into a higher power signal. The RF power amplifier for example drives the antenna of a transmitter, for instance for voice and data communication. In a particular embodiment, the RF power amplifier is based on GaN (gallium nitride) as semiconductor, for instance on a Si substrate or Si compounded substrate such as SiC substrate.

The microchip, in particular RF amplifier or other RF signal processing chip, comprises for instance a high-electron-mobility transistor (HEMT), also known as heterostructure field-effect transistor, for instance a GaN HEMT or other wide bandgap semiconductor HEMT. A HEMT, in particular based on GaN, can cause hotspot in the microchip, often due to the higher power densities. The HEMTs are for instance used as amplifier, more in particular for waveform engineering amplification.

In a particular embodiment, the microchip is a RF Power Amplifier provided as MMIC device, more in particular provided as with a GaN die. In the art for such power amplifiers, die-level heat fluxes of 1 kW/cm² or more are encountered, with hot spot heat fluxes of 30 kW/cm² or greater, wherein a hotspot is e.g. less than 1.0 mm², such as less than 0.10 mm², and with for example package-level heat removal density greater than 2.0 kW/cm³, or at least with heat production requiring such cooling with the maximum microchip temperature and ambient temperature as described. The present invention in some embodiments provides for cooling elements and cooling methods of such RF power amplifiers with such heat characteristics.

In a further embodiment, the microchip comprises a LDMOS (laterally diffused metal oxide semiconductor) transistor. The microchip comprising such a LDMOS transistor is for instance configured as microwave and/or RF power amplifier. The LDMOS transistor is for instance a silicon-based FET (field effect transistor). The microchip comprising such transistor is for instance used as RF power amplifier in a base station, preferably with envelope tracking to improve energy efficiency.

In yet a further embodiment, the microchip is based on GaAs or InGaP, such as a GaAs MMIC. GaAs is for example used as semiconductor material for low power drivers, for instance with an output power of less than 50 dBm.

In particular embodiment, the microchip is part of a radio base station, and is for example part of a baseband unit or of a remote radio unit of a radio base station. A remote radio unit is for instance used to perform digital-to-analogue conversion, analogue-to-digital conversion, frequency up-conversion and down-conversion, and power amplification. The remote radio unit is typically physically spaced apart from the baseband unit and interfaced with the frontend and/or backend of the antenna.

In a specific embodiment, the microchip is part of the remote radio unit, and more specifically is used in operation for frequency modulation and/or amplitude modulation, frequency up-conversion and/or down-conversion. In particular with these kinds of chips, the above-mentioned hotspots can occur.

In some embodiments, the microchip is configured for RF cooking. In some embodiments, the microchip is configured for operating at a frequency in the range of 1 to 2450 MHz, with example operating frequencies of 2.45 GHz and 868 MHz and 915 MHz, which are RF frequencies often used for RF cooking appliances. The microchip for instance comprises a LDMOS transistor (a laterally diffused metal oxide semiconductor transistor). Such transistors are often used in microwave and RF power amplifiers, and in particular for certain RF cooking appliances. RF cooking includes to the use of solid state RF devices for microwave ovens for in particular heating edible materials such as foods and drinks. In RF cooking appliances, the traditional cavity magnetrons for creating microwave energy is replaced by one or more microchips using solid state semiconductor technology for generating microwave energy. In some embodiments of the invention, the cooling element is used for cooling such a microchip. The use of solid state technology instead of a cavity magnetron allows for multiple microwave inputs into the oven chamber, as well as frequency and phase modulation of the RF energy thereby allowing the standing wave pattern to be varied during cooking. The RF cooking microchip can also be integrated with a gas or electric heating oven for combined heating.

The cooling element of the invention is in some embodiments arranged as an intrachip cooling element, hence as part of the microchip. More in particular the cooling liquid channels can be formed (e.g. etched) into the semiconductor substrate, e.g. Si wafer, of the microchip. In a preferred embodiment, the channels are provided in the backside of the microchip, e.g. by etching or using focused ion beams. In other embodiments, the channels are formed by the built-up of the flow-modifying structures on a backside of the microchip such as with deposition methods.

In another embodiment, the cooling element is arranged as a direct contact cooling element, which is assembled to the microchip (e.g. is bonded or connected to the microchip, in particular to the backside of the microchip). In such an embodiment the cooling element is not monolithic with the microchip. Preferably a wall of the vaporization chamber is in direct contact with a part of the microchip, more in particular with the semiconductor substrate of the microchip, and preferably in direct physical contact with the backside of the semiconductor substrate. In some embodiments, a wall of the vaporization chamber, more in particular the heat exchanging wall of the cooling element is in direct physical contact with the wafer substrate of the microchip, and more in particular in direct contact with a silicon or silicon-based substrate of the microchip.

The cooling element comprises a vaporization chamber which comprises channels and flow-modifying structures. In operation, the flow-modifying structures modify the flow of the coolant fluid (liquid and vapor) that flows through he channels thereby preventing explosive bubble growth in the vaporizing liquid.

In an example embodiment, the channels are for instance formed by the heat exchanging wall at the cover plate as bottom and top wall, and with the flow-modifying structures and the sidewalls of the casing as the vertical sidewalls of the channels.

In particular, in the cooling elements high heat dissipation rates can be achieved by preventing explosive bubble growth of the vaporizing coolant in the channels by providing the flow modifying structures in the channels, e.g. corrugations of the channel walls, wherein said structures break up the flow of the coolant in the channels.

In the present invention, vapor bubbles and liquid slugs can break up on the edges of the flow-modifying structures, in particular the pillars, and more preferably on sharp edges of the pillars, thereby increasing the surface area of the phase boundary. The annular flow type breaks down large scale oscillations.

This in particular helps to avoid or reduce the risk of local and/or intermittent dry out. It also reduces the risk of flow instabilities. In particular, it helps to avoid explosive bubble growth caused by a bubble blocking a channel, resulting in extremely fast evaporation of the remaining liquid layer on the wall at the bubble position and explosive one-dimensional growth of the bubble in the channel direction.

For example the cooling can be provided in the vaporization channels with channels and liquid slug break-up structures as described in US 2011/0000624, such as with a field of pillars as described therein.

With the flow-modifying structures of the vaporization chamber of the present invention, the risk of explosive bubble growth is reduced and very high heat dissipation rates can be achieved, such as above 0.50 kW/cm², above 1.0 kW/cm², or even above 1.5 kW/cm² at ΔT = 10 K, wherein ΔT is the temperature difference between the microchip (average on chip level) and the temperature of the incoming coolant liquid. Furthermore, a cooling power of more than 100 W/cm² at ΔT = 1 K can for instance be achieved, for example with a vaporization chamber surface of 9 mm².

In the present invention, the vaporization chamber is provided with flow modifying structures that generally break up the flow of the coolant, in particular of liquid slugs in the coolant. The structures are for instance pillars with sharp edges, and the pillars for instance are arranged in staggered rows, with the individual rows arranged perpendicular to the flow direction of the coolant. This helps to reduce the risk of explosive bubble growth of the vaporizing coolant.

Advantageously, the cooling element can be very thin, e.g. less than 0.50 mm or even less than 0.20 mm.

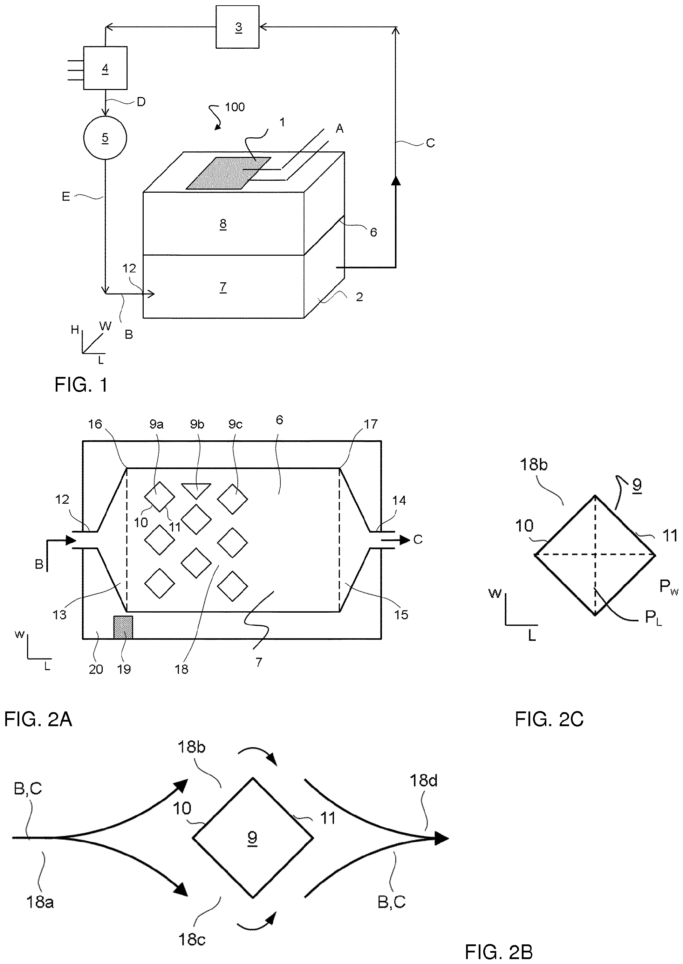

In connection with **Figures 1, 2A and 2B** (each showing an illustrative embodiment not limiting the invention), the method comprises providing a microchip (8) which comprises an integrated circuit (1) and which is assembled or integrated with a cooling element (2). The cooling element comprises a vaporization chamber (7) comprising a heat exchanging wall (6). The microchip (8), in particular the integrated circuit (1) is arranged adjacent to a first side of said heat exchanging wall (6). The heat exchanging wall (6) is impermeable to gas and liquid. The heat exchanging wall can be a part of the microchip (8). The heat exchanging wall (6) is typically electrically isolating. The heat exchanging wall allows for heat transport and preferably has a high heat conductivity. The heat exchanging wall is for instance made of Si or a Si compound material such as SiC.

The method comprises supplying cooling liquid (B) to said vaporization chamber (7), and in particular by bringing the cooling liquid (B) in contact with a second side of said heat exchanging wall (6), wherein said second side is opposite of said first side. In this way heat is exchanged from said integrated circuit to said cooling liquid (B) thereby vaporizing said cooling liquid (B) into vapor (C) while the cooling liquid (B) is in the vaporization chamber (7) to give vapour (C). In this way heat is withdrawn from the microchip, and the integrated circuit is subjected to evaporative cooling. A stream comprising vapour (C) and optionally cooling liquid (B) leaves the vaporization chamber (7).

The cooling element comprises channels (18) and a plurality of flow-modifying structures (9) that are arranged in series in the direction of the flow of the coolant liquid (B).The vaporization occurs in particular while the cooling liquid (B) flows through said channels and impinges on said flow-modifying structures (9).

The cooling element comprises an inlet (12) for coolant liquid (B) at a first side (16) of the vaporization chamber (7), and an outlet (14) for vapor (C) at an opposite second side (17) of said vaporization chamber. The vaporization chamber has a length direction (L) which is the direction from said inlet (12) to said outlet (14).

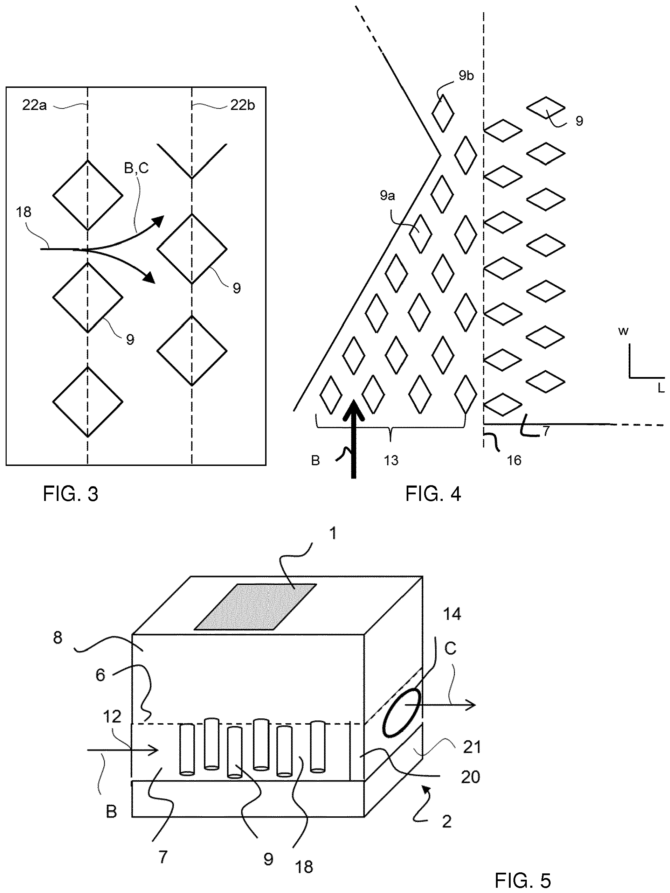

The vaporization chamber (7) preferably comprises an inlet plenum (13) between said inlet (12) and a first end (16) of said vaporization chamber (7). The inlet plenum is for instance an inlet manifold. Within this inlet manifold (13) the flow modifying structures (9b) can be arranged in such a way to promote optimal flow distribution in width direction (W), see also Fig. 4.

Preferably the coolant is not in heat exchanging contact with the first stream in said inlet plenum (13). For instance a thermally insulating material or a gap can be applied between the inlet plenum (13) and the microchip, the inlet plenum (13) may e.g. also extend parallel beyond or perpendicular to the microchip.

Preferably, said wall (6) is arranged downstream of said inlet plenum. The inlet plenum is for example a manifold and is for example provided with fins or other structures to distribute the coolant especially over the width of the vaporization chamber (7).

At the outlet (14), the coolant stream may also contain liquid coolant. The heat exchanger for instance further comprises outlet plenum (15) between said second end (17) and said outlet (14).

In some embodiments, the inlet plenum is perpendicular or at some angle to the vaporization chamber. In some embodiments, the outlet plenum is perpendicular or at some angle to the vaporization chamber.

Preferably the first end (16) is positioned at the place of initial heat exchanging contact between the microchip and the coolant liquid (B) through wall (6). Preferably the second end (17) is positioned at the place of terminal heat exchanging contact between the microchip and the vapour (C) and/or liquid (B) in the vaporization chamber (7) through the wall (6), for one passage of coolant through the vaporization chamber.

The cooling method for example comprises flowing coolant liquid (B) from said first end (16) to said second end (17). During this flow, at least part of the flowing coolant (B, C) is subjected to multiple flow modifications (in series) while flowing in said vaporization chamber (7) from first end (16) and to the second end (17), and while in contact with the heat exchanging wall (6). Each flow modification comprises a step of dividing the flow of coolant into two streams, and a step of combining at least two streams of coolant into a single stream. Preferably, the steps of dividing and combining are alternating. In this way liquid slugs are broken up.

In the present invention, the vaporization chamber vaporization chamber (7) comprises a plurality of flow-modifying structures (9), and preferably the heat exchanging wall (6) is monolithic with the flow-modifying structures (9). The method comprises a step of contacting the coolant with these structures, in particular by flowing the coolant liquid (B) around these structures through the vaporization chamber. These structures are arranged in series in the direction of the flow of coolant (coolant liquid (B) and vapor (C)) and are arranged for contact with the coolant fluid. In particular, the flow of the coolant liquid (B) and the vapor (C) is modified while the coolant liquid (B) and the vapor (C) flow through said channels (18) in said vaporization chamber (7) while simultaneously the coolant liquid (B) and the vapor (C) are in contact with said heat exchanging wall (6). Accordingly, the flow-modifying structures (9) are arranged in the vaporization chamber (7) at a position in the length direction where also the heat exchanging wall (6) is provided. The structures (9) are each configured for modifying the flow of the coolant liquid (B) and the vapour (C) in said vaporization chamber (7). The flow-modifying structures (9) are provided in the part of the vaporization chamber where the coolant in in heat-exchanging contact with the microchip (8) and where the coolant vaporizes.

The structures (9) are preferably positioned such that vaporizing coolant contacts multiple of said structures in series, in particular positioned such that vaporizing coolant contacts multiple of said structures in series in a single vaporization chamber. The vaporizing coolant preferably impinges on the structures (9) which are for instance protrusions of the wall (6). The structures (9) are spaced apart in the vaporization chamber and the spaces between them define channels (18) for the coolant. The structures are preferably arranged such that coolant flowing in such a channel (18) impinges on a structure (9) and is divided in at least two streams in channels that are separated from each other by a separation, preferably by said structure (9). In addition, the structures (9) are preferably also arranged such that channels (18) are also combined.

Preferably, the flow-modifying structures each have a width P_{w} as maximum size in the width direction W and a length P_{L} as maximum size in the length direction L (as is shown in Fig. 2C). The ratio of the length P_{L} to the width P_{w} is preferably less than 10:1 or less than 5:1, and is typically larger than 1:1, for instance larger than 2:1 (e.g. elongated pillars in the flow direction).

More in particular, each of the flow-modifying structures (9a, 9b, 9c) preferably comprises a first part and a second part, preferably a upstream end part and a downstream end part (with respect to the flow of coolant around the structure). By the first part (10) a channel (18a) for coolant is divided into two channels (18b, 18c) for coolant. Preferably the at least two channels (18b, 18c) are separated from each other by at least a part of said flow-modifying structure. Preferably the at least two channels are separated in the width direction of the vaporization chamber, wherein the width direction is parallel to the heat exchanging wall (6) and perpendicular to said length direction. The two channels run for example at an angle in the range of 5° to 85° to the length of the reactor. The second part (11) is arranged downstream of the first part (10) with respect to the flow of coolant. The first part preferably comprises a sharp edge protruding in the upstream direction to break up coolant. By the second part at least two channels for coolant are combined into a single channel (18d) for coolant.

The channels (18) and structures (9) provide for increased heat exchange area. Because the channels are typically small (small width), the surface tension forces are important relative to inertia. This enhances flow distribution and promotes annular flow. Vapour bubbles and liquid slugs break up on the first part of the structures, promoting an overall bubbly flow pattern and/or annular flow. A flow of the annular flow type reduces large scale oscillations of the flow.

Generally, the flow-modifying structures (9) protrude perpendicular from said wall (6) into said vaporization chamber (7). The flow-modifying structures (9) are preferably protrusions of the heat-exchanging wall (6), and can alternatively also be protrusions of a cover plate (21) of the vaporization chamber.

The structures (9) are for instance integrally formed and unitary with the wall (6), for instance the structures (9) and the wall (6) are monolithic. The structures (9) are for instance pillars.

The structures (9) are for instance provided by forming recesses in the wall (6). The wall is for instance monolithic with the microchip (8), or is for instance a separate piece of material, e.g. a separate piece of silicon which is assembled to the microchip, in particular to the backside of the microchip. The recesses are for example etched into the material of the wall (6) during manufacture of the cooling element.

Preferably the cooling element (2) comprises a casing. Preferably the cooling element is a plate type heat exchanger.

**Figure 3** shows a preferred embodiment of the structures in top view. The vaporization chamber (7) comprises staggered rows (22a, 22b) of pillars (9). The pillars protrude from the wall (6). The rows are distributed over said length direction (L) of the vaporization chamber (7), i.e. are placed at various positions over the flow path between said inlet (12) and said outlet (14). Typically the centres of the pillars of each row are spaced apart in the length direction between the rows. Each row typically extends in the width direction, and in each row (22) the pillars (9) are distributed and spaced apart in the width direction (W) transversal to said length direction (L). In each row, the centres of the pillars can have the same or different positions in the length direction. For a pair of neighbouring rows (22a,22b), the pillars (9) have a different position in said width direction (W). This provides for an arrangement wherein the rows of pillars are staggered. The arrangement in rows is preferably and not necessary. For instance an irregular arrangement of pillars can also be used. The arrangement of pillars is typically staggered and such that from first and to second end, there are at least 1, at least 2, at least 3, or even at least 10 pillars provided at each position in width direction. This avoids that a part of the coolant can flow from first end to second end at one without encountering a pillar.

Preferably, the vaporization chamber (7) is provided with an internal structure. Preferably, the cross section of the evaporation volume is substantially constant along the main flow path for coolant in the vaporization chamber (7) from inlet to outlet of said chamber. This refers in particular to the cross section perpendicular to the flow direction e.g. the length direction. Preferably, the surface area of the flow path for coolant is said cross-section is substantially constant (such as less than 10% difference between minimum and maximum, based on the maximum) in said flow direction. Preferably, the internal structure comprises a regular pattern. For instance, the internal structure is a field (array) of pillars. The pillars for example protrude from the heat exchanging wall (6). Preferably the pillars are arranged in a staggered way.

Preferably, the pillars have in cross section in the plane parallel to said wall (6) a shape that is e.g. diamond shape, rectangular shape, hexagonal, triangular, circle, or elliptical. Shapes with a sharp edge (e.g. less than 60°) of the upstream part (10) are preferred. The edge line preferably extends perpendicular to the heat exchanging wall (6).

Preferably, the interior of the shape is a convex set, i.e. every point of a line segment that joins a pair of points on said cross-section is inside the pillar. This avoids pillars that are hollow or have indents.

Preferably, the channels (18) between two flow-modifying structures (e.g. between two pillars in a row, or between rows of pillars) have a width of less than 1.0 mm, more preferably less than 0.5 mm, or less than 100 µm, or even less than 50 µm. The coolant channels width is preferably above 5 µm or preferably above 10 µm, in view of the pressure drop. The coolant channel width is e.g. the spacing between walls extending perpendicular to the heat exchanging wall (6) defining a channel (18) between them, and is e.g. the spacing between neighbouring two flow-modifying structures, e.g. between two pillars, defining a channel (18) between them. Preferably the flow-modifying structures, e.g. pillars, have a spacing (between neighbouring pairs) of less than 1.0 mm, less than 0.5 mm, less than 100 µm or even less than 50 µm and typically above 5 µm or above 10 µm.

In a preferred embodiment, the method further comprises passing the vapour (C) through a pressure vapor chamber (3) to accommodate excess fluid pressure.

The method further preferably comprises condensing the vapour (C) in a condenser (4) arranged downstream the pressure vapor chamber (3) to give condensate liquid (D), and preferably passing the condensate (D) through a valve (5). The condenser, the valve (5), and/or at least a tube connection part between them, are preferably arranged vertically above the vaporization chamber (7), with respect to gravity, and are preferably vertically spaced apart from the vaporization chamber (7). Preferably they are spaced apart from the vaporization chamber, more in particular the inlet (12) thereof in vertical direction (with respect to gravity) by at least 5 cm or at least 10 cm or at least 15 cm, and for instance less than 50 cm. Preferably in particular the condenser is at least 5 cm or at least 10 cm or at least 20 cm higher than the inlet (12) of the vaporization chamber with respect to gravity. The condenser (4) preferably has fins, e.g. for heat exchange with ambient air.

Preferably a liquid column of coolant liquid (B) is maintained upstream of the inlet (12), e.g. of at least 5 cm or at least 10 cm height, such as to give a pressure head at inlet (12) which drives the flow of the coolant liquid (B) through the vaporization chamber (7). Preferably the pressure head (i.e. static pressure difference) is sufficient to overcome the pressure drop of the vaporization chamber (7). Hence, the coolant is contained in a closed loop and is kept in motion without the use of a pump. The thermal energy from the microchip (8), in particular the integrated circuit, is effectively used for movement of the coolant fluid.

For example, with a liquid head height of 20 cm, a static pressure difference of 10- 15 mbar can be available, which very elegantly allows for a no-pump system if in the vaporization chambers pillars are used with a spacing of more than 0.2 mm, giving for a typical configuration with staggered rows of pillars and a 10mmx10mm heat exchanging zone, a pressure drop of about 5 mbar, such that the liquid head can maintain the flow through the vaporization chamber.

Hence, in a preferred embodiment, the method further comprises condensing said vapor in a condenser to liquid, wherein transport of the vapor to the condenser and transport of the liquid from the condenser to the vaporization chamber and transport of the cooling fluid through the vaporization chamber is effected without using a pump, e.g. without using a mechanical pump with moving parts. This in particular makes the cooling element (or cooling system) more reliable.

Hence, in preferred embodiment, the cooling method uses a preferred cooling element comprising a condenser arranged vertically above the vaporization chamber, wherein the condenser has an inlet with a first connection to said outlet (14) for vapor (C) and has an outlet with a second connection, preferably through a one way valve, to the inlet (12) for coolant liquid (B), wherein preferably the one-way valve is arranged vertically above the vaporization chamber. In this preferred cooling method embodiment, at least vapor (C) flows up through the first connection to the condenser. Preferably it is condensed to liquid (B) in the condenser by heat exchange against ambient air. Preferably only the liquid (B) flows down from the one-way valve through the second connection by gravity flow thereby driving transport of the liquid (B) through said vaporization chamber.

Preferably, condenser operates at a condensation temperature of less than 70°C, more preferably less than 50°C, even more preferably less than 30°C, for example less than 10°C. Preferably the liquid has, at the operating pressure of the vaporization chamber, a vaporization temperature of less than 70°C or preferably less than 50°C, more preferably less than 30°C. The operating pressure of the vaporization chamber and/or condenser can be above 1 bar absolute, e.g. above 5 bar or above 10 bar.

Preferably, the cooling liquid comprises ammonia (NH₃), e.g. at least 50 wt.% or at least 90 wt.% NH₃, rest e.g. water, for instance a mixture with at least 10 wt.% water (all percentages based on total composition). Ammonia has a lower boiling point than water and allows for cooling to lower temperatures than can be achieved with water. For instance with a operation pressure in the vaporization chamber of 10 bar, the boiling point of 100 wt.% NH₃ is about 25°C which allows for evaporative cooling at this advantageous low temperature.

The coolant comprises for instance an organic substance. The coolant typically has a lower boiling point (i.e. boiling point temperature) than water (at the same pressure). The invention implements for instance an Organic Rankine Cycle. Generally, a lower boiling point increases the efficiency of the heat exchanger. Some examples of suitable coolants include alcohols such as methanol, ethanol and propanol, hydrocarbons such as isobutene, pentene and propane; and hydrofluorocarbons such as R143a (1,1,1,2-tetrafluoroethane), as well as ketones such as aldehyde, formaldehyde, acetaldehyde, propanal,butanal, isobutyraldebhyde, and for example also mixtures of ketones with water. As particular example a mixture containing formaldehyde and water can be mentioned. Examples of suitable coolants include 1234 yf (2,3,3,3-tetrafluoroprop-1-ene) and HFO-1234ze(E) ((1E)-1,3,3,3-tetrafluoro-1-propene).

The coolant is for instance a (organic) refrigerant compound. Further suitable coolants include water, ammonia and acetone. Mixtures of these can also be used as coolant, e.g. a mixture of water with an alcohol, aldehyde or with ammonia.

In a preferred embodiment, a part of the vaporization chamber, more preferably at least the heat exchanging wall of the cooling element, is made of a silicon-based material. Preferably the flow-modifying structure are also made of a silicon-based material.

The invention also pertains to a cooling element suitable for cooling a microchip as described in connection with the cooling method. The cooling element is preferably as discussed in connection with the cooling method. Preferably the heat exchanging wall (6) and/or the flow-modifying structures (9) are monolithic with each other and the heat exchanging wall (6) and/or the flow-modifying structures (9) are preferably made of a silicon based material, such as Si or SiC. This makes the cooling element particularly suitable for assembly with a microchip. Advantageously very good heat transfer from an integrated circuit of a microchip to such an cool element can be obtained The cooling element may be a separate device that is for instance assembled with a microchip, for example by mounting to the backside of the microchip. Particularly preferably the mounting or assembly provides for direct Si-on-Si contact between the microchip substrate and the heat exchanging wall of the cooling element.

The invention also pertains to an assembly comprising a microchip and a cooling element as described. The microchip is preferably as described, and is e.g. a RF power amplifier.

In a preferred embodiment of the assembly the flow-modifying structures (9) extend perpendicular to said heat exchanging wall (6) into said vaporization chamber (7), wherein said vaporization chamber (7) comprises as said protrusions staggered rows (22a, 22b) of pillars (9). The pillars and staggered rows are preferably as described in connection with the cooling method.

In a preferred assembly the microchip comprises an integrated circuit transmitter and/or receiver for wireless communication using electromagnetic radiation with a frequency of at least 24 GHz.

In preferred embodiment of the assembly, the microchip and the cooling element each comprise a part made of a silicon material and these parts (of the cooling element and of the microchip) are in direct physical contact. Preferably, the heat exchanging wall (6) is in direct physical contact with the backside of a substrate of the microchip. The cooling element is for instance joined, connected, and/or bonded to the microchip, in particular to the backside of the microchip.

In another preferred embodiment of the assembly, the flow-modifying structures (9) are monolithic with the heat exchanging wall (6) and with a substrate of said microchip (8). Preferably vaporization chamber comprises a cover plate (21) which is assembled with the microchip, e.g. is bonded or connected to microchip, e.g. to the backside of the microchip.

The invention also pertains to a manufacturing method for manufacturing a cooling element as described. Preferably, the flow-modifying structures (9) are pillars (9) extending perpendicular to said heat exchanging wall (6) into said vaporization chamber (7). Preferably the method comprises the method comprising forming channels (18) in a silicon wafer substrate, e.g. by etching or ablation, e.g. using a focused ion beam, such that the material (e.g. Si material) remaining between the channels provides the flow-modifying structures.

**Figure 1** schematically illustrates an example assembly (100) with the cooling element (2), the pressure vapor chamber (3), the condenser (4), and the one way valve (5) which prevents flow of gas and liquid in reverse direction from inlet 12 to condenser 4. The cooling element (2) comprises the vaporization chamber (7) adjacent to the backside of the microchip (8) which has an integrated circuit (1) on the topside. The cooling element (2) comprises a heat exchanging wall (6) between the vaporization chamber (7) and the microchip. Also shown are the coolant liquid condensate (E) and the coolant liquid (B) flowing from the valve (5) to the cooling element (2), in particular to the inlet (12) of the vaporization chamber (7), and the vapour (C) flowing from the outlet (14) to the chamber (3) and then to the condenser (4). The camber (3) can be used as expansion vessel to absorb excess fluid pressure. For the cooling element (2), the length (L) is parallel to the coolant flow in chamber (7), and the width (W) is perpendicular to (L) and parallel to wall (6). In Figure 1, the vaporization chamber (7) is mounted horizontal and the height (H) is perpendicular to the wall (6) and vertical with respect to gravity. The condenser (4) and the valve (5) are arranged above (with respect to gravity) and vertically spaced from the inlet (12) of the vaporization chamber (7), so as to maintain a liquid head (E). The integrated circuit (1) has for instance a number of electrical leads (A) for connection with e.g. a printed circuit board (not shown), for instance integrated circuit (1) is a RF power amplifier and at least one of the leads (A) is an outlet for an amplified RF signal to an antenna (not shown).

**Figure 2A** shows a schematic top view of an example cooling element according to the invention with a vaporization chamber (7) with structure (9) (a pillar) with first part (10) and second part (11) and channels (18) between the pillars (9a, 9b, 9c). The three pillars (9a, 9b, 9c) are arranged in series along the flow from first end (16) to second end (17), said ends (16,17) of the vaporization chamber (7) define a heat exchanging zone, with the preferred inlet plenum (13) between the inlet (12) and the first end (16), and with the optional outlet plenum (15) between the second end (17) and the outlet opening (14). Optional heat flow restriction (19) is for instance a slot in the casing (20). The heat flow restriction (19) is for instance used to provide for thermal insulation between the heat exchanging wall (6) of the vaporization chamber (17) and the inlet plenum (15). The pillars (9) are shown as diamonds in top view, but many other shapes are also possible, such as ellipses and circles.

**Figure 2B** shows an expanded top view of a pillar (9). At the first part (10) of pillar (9), a first channel (18a) is dived in two channels (18b,18c) that are separated by the pillar (9). At the second part (11) of pillar (9), the two channels (18b, 18c) are combined into a single channel (18d). Hence, any liquid slugs present in the first channel (18a) are converted into an overall bubbly flow pattern or an annular flow in the divided channels (18b,18c). The combination of first part (10) second part (11) advantageously provides for substantially the same width of the vaporization chamber over its length.

**Figure 2C** shows an expanded top view of a pillar (9) which has a pillar width PW as maximum size in the width direction W and a pillar length P_{L} as maximum size in the length direction L. The ratio pillar of the length P_{L} to pillar width PW is illustrated as 1:1 and is generally less than 10:1 or less than 5:1.

**Figure 3** shows a top view of an example cooling element showing two staggered rows (22a, 22b) of the pillars (9). After passing through the channels (18) between the pillars of the first upstream row (22a), the coolant is broken up on the sharp vertical edges of the pillars of the second row (22b).

**Figure 4** shows a further top view of an example cooling element according to the invention with staggered rows of pillars (9a, 9b, 9c) in the vaporization chamber, wherein the pillars have different orientation so as to provide in part for an inlet manifold (13). The pillars (9a,9b) in inlet manifold (13) have a different orientation from the pillars (9) in the vaporization chamber (7). In the inlet manifold (13), the pillars (9b) are arranged for distributing the liquid (B) over the width direction (W). The first end (16) of heat exchanging zone is indicated between the inlet manifold (13) and the vaporization chamber (7); chamber (7) provides the heat exchanging zone.

**Figure 5** schematically illustrates an example embodiment of an assembly wherein the heat exchanging wall 6 and the flow-modifying structures (9) (e.g. pillars) are both monolithic with the microchip (8). For instance the channels (18) are etched in the backside of the microchip (8), e.g. as gutters, to form the pillars (9). A cover plate (21) is a separate piece of material and is joined to vaporization chamber, e.g. to the casing (20) of the vaporization chamber, for example at a part of the casing (20) that is a sidewall of the vaporization chamber (7) and that is monolithic with the microchip (8). Hence cover plate (21) is mounted as a lid on the vaporization chamber (7).

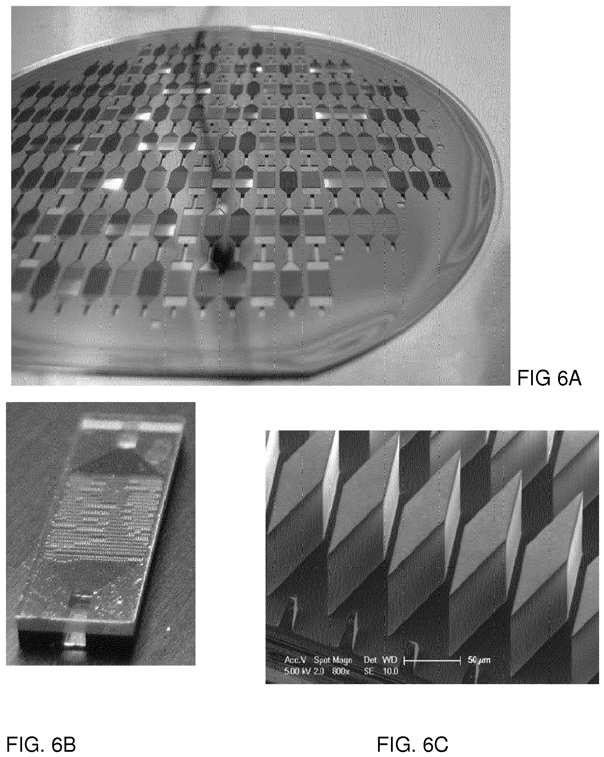

**Figure 6** shows images of an example cooling unit that was manufactured. Fig. 6A shows a photograph a wafer with a number of vaporization chambers according to the invention. Fig. 6B shows an image of an individual vaporization chamber of the manufacture example. Fig. 6C shows a magnified electron microscopy image of the pillars; the scale bar is 50 µm. The channels are e.g. 20 µm width, the pillar height is e.g. 50 µm and the pillar length is e.g. 100 µm.

The reference numerals used in the description and in the claims are illustrative only and for understanding the drawings and do not limit the invention or the claims.

## Claims

1. A method of cooling a microchip, which microchip (8) comprises an integrated circuit (1) and is assembled or integrated with a cooling element (2),
wherein the cooling element comprises a vaporization chamber (7) comprising a heat exchanging wall (6), wherein the integrated circuit is arranged adjacent to a first side of said heat exchanging wall (6),
wherein the method comprise providing a cooling liquid (B) to said vaporization chamber (7) in contact with a second side of said heat exchanging wall (6), wherein said second side is opposite of said first side, such that heat is exchanged from said integrated circuit to said cooling liquid (B) thereby vaporizing said cooling liquid (B) into vapor (C)
wherein the vaporization chamber (7) comprises channels (18) and a plurality of flow-modifying structures (9) that are arranged in series in the direction of the flow of the coolant liquid (B), such that the flow of the coolant liquid (B) and the vapor (C) is modified while the coolant liquid (B) and the vapor (C) flow through said channels (18) in said vaporization chamber (7) and in contact with said heat exchanging wall (6),
and wherein the cooling element comprises an inlet (12) for coolant liquid (B) at a first side (16) of the vaporization chamber (7), and an outlet (14) for vapor (C) at an opposite second side (17) of said vaporization chamber, wherein a length direction (L) of the vaporization chamber (7) is from said inlet (12) to said outlet (14).

2. A method according to claim 1, wherein each of said flow-modifying structures (9a, 9b, 9c) comprises:
- a first part (10) wherein a channel (18a) for coolant is divided in two channels (18b, 18c) for coolant, wherein the channels are separated in the width direction of the vaporization chamber, wherein the width direction is parallel to the heat exchanging wall (6) and perpendicular to said length direction,
- and a second part (11), arranged downstream of the first part (10), wherein at least two channels (18b, 18c) for coolant are combined into a single channel (18d) for coolant.

3. A method according to claim 1 or 2, wherein said flow-modifying structures (9) are pillars (9) extending perpendicular to said heat exchanging wall (6) into said vaporization chamber (7), wherein pillars (9) are arranged in staggered rows (22a, 22b),
- wherein said rows are distributed over said length direction (L) of the vaporization chamber (7),
- wherein in each row (2) the pillars (9) are distributed in a width direction (W) transversal to said length direction (L),
- and wherein for a pair of neighbouring rows (22a, 22b), the pillars (9) have a different position in said width direction (W), such that the rows of pillars are staggered.

4. A method according to any of the preceding claims, wherein at least said heat exchanging wall of said cooling element is made of a silicon-based material.

5. A method according to any of the preceding claims, wherein said microchip has a chip-level heat dissipation level of more than 1 kW/cm².

6. A method according to any of the preceding claims, wherein the cooling element furthermore comprises a condenser (4) arranged vertically above the vaporization chamber, wherein the condenser has an inlet with a first connection to said outlet (14) for vapor (C) and has an outlet with a second connection to said inlet (12) of the vaporization chamber (7),
wherein in the method, at least vapor (C) flows up through said first connection to said condenser and is condensed to liquid (B) in said condenser by heat exchange against ambient air, and wherein only said liquid (B) flows down from said one-way valve through said second connection by gravity flow, thereby driving transport of said liquid (B) through said vaporization chamber.

7. The method of claim 6, wherein said condenser operates at a condensation temperature of less than 70°C, and wherein said liquid has, at the operating pressure of the vaporization chamber, a vaporization temperature of less than 70°C.

8. The method of claim 7, wherein the liquid comprises NH₃.

9. The method according to any of claims 1-8, further comprising condensing said vapor in a condenser to liquid, wherein transport of the vapor to the condenser and transport of the liquid from the condenser to the vaporization chamber and transport of the cooling fluid through the vaporization chamber is effected without using a pump.

10. The method of claim 1, wherein the microchip simultaneously generates alternating current of at least 20 kHz to an antenna.

11. An assembly comprising a microchip and a cooling element,
wherein the microchip is provided with an integrated circuit,
wherein the cooling element comprises a vaporization chamber comprising a heat exchanging wall (6), wherein the microchip is arranged adjacent to a first side of said heat exchanging wall (6),
wherein the heat exchanging wall is configured for, in operation, exchanging heat from said microchip to a cooling liquid (B) that is provided in said vaporization chamber in contact with a second side of said heat exchanging wall (6), wherein said second side is opposite of said first side, thereby vaporizing said cooling liquid into vapor (C),
wherein the vaporization chamber (7) comprises channels (18) and a plurality of flow-modifying structures (9) that are arranged in series in the direction of the flow of the coolant liquid (B) and that are each configured for modifying the flow of the coolant liquid (B) and the vapor (C) while the coolant liquid (B) and the vapor (C) are in said vaporization chamber and in contact with said heat exchanging wall (6), and wherein the cooling element comprises an inlet (12) for coolant liquid (B) at a first side (16) of the vaporization chamber (7), and an outlet (14) for vapor (C) at an opposite second side (17) of said vaporization chamber.

12. The assembly of claim 11, wherein said flow-modifying structures (9) extend perpendicular to said heat exchanging wall (6) into said vaporization chamber (7),
wherein said vaporization chamber (7) comprises as said protrusions staggered rows (22a, 22b) of pillars (9).

13. The assembly of claim 11 or 12, wherein said microchip comprises an integrated circuit transmitter and/or receiver for wireless communication using electromagnetic radiation with a frequency of at least 24 GHz.

14. The assembly of any of claims 11-13, wherein said microchip and said cooling element each comprise a part made of a silicon material, wherein said parts are in direct physical contact, and/or wherein said heat exchanging wall (6) is in direct physical contact with the backside of a substrate of the microchip.

15. The assembly according to any of claims 11-13, wherein said flow-modifying structures (9) are monolithic with said heat exchanging wall (6) and with a substrate of said microchip (8), and wherein the vaporization chamber comprises a cover plate (21) which is assembled with the microchip.

16. A cooling element suitable for cooling a microchip,
wherein the cooling element (2) comprises a vaporization chamber (7) comprising a heat exchanging wall (6) having a first side where, in operation, heat from an integrated circuit (1) comprised in said microchip is provided, and a second side which is, in operation, in contact with a cooling liquid (B) provided in the vaporization chamber (7) such that said cooling liquid (B) is vaporized to vapor (C),
wherein said second side is opposite of said first side,
wherein the vaporization chamber (7) comprises channels (18) and a plurality of flow-modifying structures (9) that are arranged in series in the direction of the flow of the coolant liquid (B) and that are each configured for modifying the flow of the coolant liquid (B) and the vapor (C) while the coolant liquid (B) and the vapor (C) are in said channels (18) in said vaporization chamber and in contact with said heat exchanging wall (6),
wherein the cooling element comprises an inlet (12) for coolant liquid (B) at a first side (16) of the vaporization chamber (7), and an outlet (14) for vapor (C) at an opposite second side (17) of said vaporization chamber (7),
and wherein said heat exchanging wall (6) and said flow-modifying structures (9) are monolithic with each other and are made of a silicon based material.

17. A method of manufacturing a cooling element according to claim 16,
wherein in said cooling element, said flow-modifying structures (9) are pillars (9) extending perpendicular to said heat exchanging wall (6) into said vaporization chamber (7),
the method comprising etching channels (18) in a silicon wafer substrate, such that the silicon material remaining between the channels provides the flow-modifying structures.
